(19) **Europäisches Patentamt / European Patent Office / Office européen des brevets**

(11) **EP 3 889 617 B1**

(12) # FASCICULE DE BREVET EUROPEEN

(45) Date de publication et mention de la délivrance du brevet:
**30.07.2025 Bulletin 2025/31**

(21) Numéro de dépôt: **21166847.0**

(22) Date de dépôt: **02.04.2021**

(51) Classification Internationale des Brevets (IPC):
*G01P 15/097 (2006.01)*  *G01P 15/13 (2006.01)*
*G01P 15/08 (2006.01)*  *G01C 19/5776 (2012.01)*
*G01C 19/5726 (2012.01)*

(52) Classification Coopérative des Brevets (CPC):
**G01P 15/097; G01C 19/5726; G01P 15/13;**
G01P 2015/0865

(54) **PROCÉDÉ DE COMMANDE D'UN CAPTEUR**

VERFAHREN ZUR STEUERUNG EINES SENSORS

SENSOR CONTROL METHOD

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **03.04.2020 FR 2003380**

(43) Date de publication de la demande:
**06.10.2021 Bulletin 2021/40**

(73) Titulaire: **Commissariat à l'Energie Atomique et aux Energies Alternatives
75015 Paris (FR)**

(72) Inventeurs:
• **SANSA PERNA, Marc**
**38054 GRENOBLE CEDEX 9 (FR)**
• **DEFOORT, Martial**
**38000 GRENOBLE (FR)**

(74) Mandataire: **Cabinet Beaumont
4, Place Robert Schuman
B.P. 1529
38025 Grenoble Cedex 1 (FR)**

(56) Documents cités:
**EP-A1- 3 301 398      US-A1- 2009 064 781
US-A1- 2014 208 823**

• **NAN-CHYUAN TSAI ET AL: "Fabrication and analysis of a micro-machined tri-axis gyroscope", JOURNAL OF MICROMECHANICS AND MICROENGINEERING, INSTITUTE OF PHYSICS PUBLISHING, BRISTOL, GB, vol. 18, no. 11, 1 November 2008 (2008-11-01), pages 115014, XP020145032, ISSN: 0960-1317, DOI: 10.1088/0960-1317/18/11/115014**

EP 3 889 617 B1

**Description**

Domaine technique

La présente description concerne de façon générale les dispositifs électroniques et, plus particulièrement, les capteurs basés sur des microsystèmes électromécaniques (en anglais MicroElectroMechanical Systems - MEMS) et leurs procédés de commande.

Technique antérieure

Un capteur basé sur un microsystème électromécanique, ou capteur MEMS, comprend typiquement un élément mécanique de dimensions micrométriques sensible à une grandeur physique, par exemple à une accélération, à une vitesse angulaire, à une force, etc. Cet élément mécanique est généralement associé à un ou plusieurs éléments de transduction, ou transducteurs, capables de convertir des mouvements de l'élément mécanique en des signaux électriques ou optiques représentatifs de la grandeur physique à mesurer.

Dans les capteurs MEMS usuels, des circuits électroniques permettent notamment de commander les éléments de transduction et de traiter les signaux qui en sont issus. De tels circuits sont souvent complexes et coûteux à réaliser.

Le document de Nan-Chyuan Tsai et al. intitulé « Fabrication and analysis of a micro-machined tri-axis gyroscope » (J. Micromech. Microeng. 18 (2008), 115014) décrit la fabrication et l'analyse d'un gyroscope à trois axes micro-usiné.

Le document EP 3301398 décrit un gyroscope MEMS ayant une stabilité élevée par rapport aux variations de température et d'humidité.

Le document US 2009/064781 décrit une méthode de lecture et un contrôle de largeur de bande électronique pour un gyroscope à diapason plan en silicium.

Résumé de l'invention

Il existe un besoin d'améliorer les circuits des capteurs MEMS existants.

Un mode de réalisation pallie tout ou partie des inconvénients des circuits des capteurs MEMS connus.

L'invention est définie par la revendication 1. Les revendications dépendantes couvrent des modes de réalisation et variantes de l'invention.

Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :

la figure 1 représente, de façon très schématique et partielle, un exemple d'accéléromètre ;

la figure 2 est une vue de côté, schématique et partielle, d'un autre exemple d'accéléromètre du type auquel s'appliquent, à titre d'exemple, des modes de réalisation décrits ;

la figure 3 représente, de façon schématique et sous forme de blocs, un exemple de circuit de commande d'un capteur ;

la figure 4 est un graphique représentant des courbes caractéristiques de l'accéléromètre de la figure 2 ;

la figure 5 représente, de façon schématique et sous forme de blocs, un mode de réalisation d'un circuit de commande d'un capteur ;

la figure 6 comprend des graphiques représentant d'autres courbes caractéristiques de l'accéléromètre de la figure 2 ;

la figure 7 est une vue en perspective, schématique et partielle, d'encore autre exemple d'accéléromètre du type auquel s'appliquent, à titre d'exemple, des modes de réalisation décrits ; et

la figure 8 représente, de façon schématique et sous forme de blocs, un autre mode de réalisation d'un circuit de commande d'un capteur.

Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés. En particulier, les applications et dispositifs dans lesquels les capteurs décrits sont susceptibles d'être mis en œuvre ne sont pas détaillés.

Sauf précision contraire, lorsque l'on fait référence à deux éléments connectés entre eux, cela signifie directement connectés sans éléments intermédiaires autres que des conducteurs, et lorsque l'on fait référence à deux éléments reliés (en anglais "coupled") entre eux, cela signifie que ces deux éléments peuvent être connectés ou être reliés par l'intermédiaire d'un ou plusieurs autres éléments.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence, sauf précision contraire, à l'orientation des figures.

Sauf précision contraire, les expressions "environ", "approximativement", "sensiblement", et "de l'ordre de" signifient à 10 % près, de préférence à 5 % près.

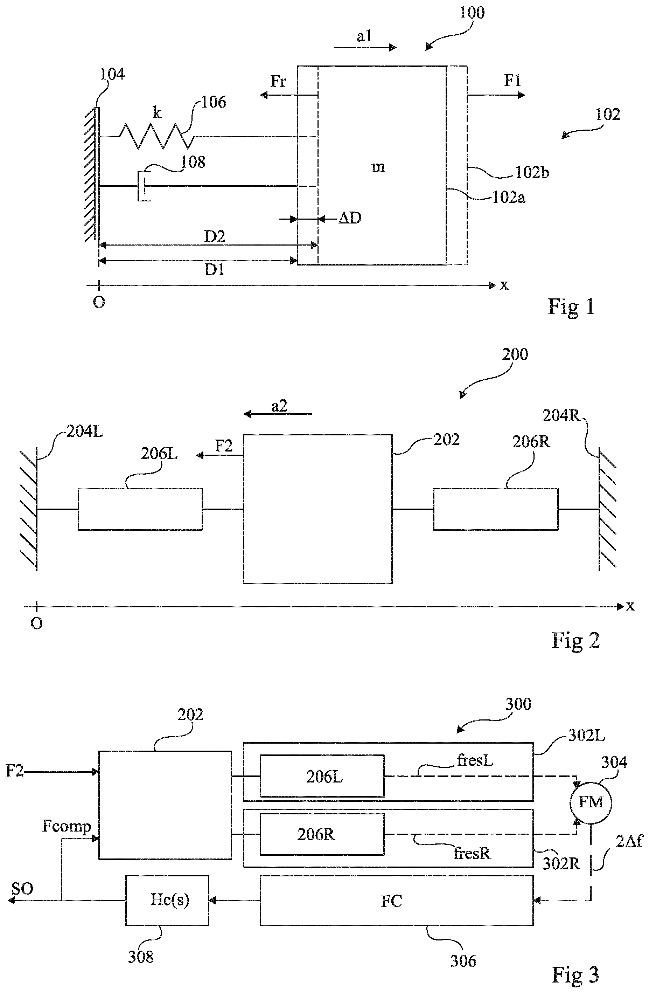

La figure 1 représente, de façon très schématique et partielle, un exemple d'accéléromètre 100.

Dans l'exemple de la figure 1, l'accéléromètre 100 comporte un corps d'épreuve 102, par exemple une masse sismique de masse m. La masse sismique 102 est reliée à un élément fixe ou ancrage 104 par un ressort 106, de constante de raideur k, et par un amortisseur 108 monté en parallèle du ressort 106. Dans la représentation schématique de la figure 1, l'amortisseur 108 permet de modéliser des pertes dynamiques ou phénomènes d'amortissement, par exemple des pertes par frottement, susceptibles d'affecter le fonctionnement de l'accéléromètre 100.

Au repos, autrement dit en l'absence d'accélération, la masse sismique 102 est séparée de l'ancrage 104 par une distance D1. En figure 1, la position de la masse sismique 102 au repos est symbolisée par un rectangle 102a en trait plein.

Lorsque la masse sismique 102 est écartée de la position 102a, par exemple sous l'effet d'une force F1 résultant d'une accélération a1, le ressort 106 exerce alors, sur la masse sismique 102, une force Fr. Dans le cas illustré en figure 1 où la force F1 tend à éloigner la masse sismique 102 par rapport à l'ancrage 104, la force Fr est une force de rappel s'opposant à la force F1, c'est-à-dire tendant à rapprocher la masse sismique 102 par rapport à l'ancrage 104.

En supposant que l'accélération a1 soit constante, la masse sismique 102 atteint alors une position d'équilibre statique, symbolisée en figure 1 par un rectangle 102b en trait pointillé, dans laquelle la force de rappel Fr compense la force F1. Les forces Fr et F1 sont dans ce cas de même valeur et de même direction, parallèle à un axe horizontal Ox, mais de sens opposés.

Dans la position d'équilibre 102b, la masse sismique 102 est séparée de l'ancrage 104 par une distance D2, supérieure à la distance D1. En mesurant le déplacement de la masse sismique 102, autrement dit en évaluant un écart $\Delta D$ entre les distances D1 et D2, on peut alors, connaissant la masse m et la constante de raideur k, en déduire l'accélération a1 subie par la masse sismique 102 de l'accéléromètre 100.

Dans la suite de la description, on désigne par résolution d'un accéléromètre l'accélération minimale susceptible d'être détectée par cet accéléromètre. En d'autres termes, la résolution d'un accéléromètre correspond à la plus petite force, ou au déplacement minimal, détectable par cet accéléromètre.

La figure 2 est une vue de côté, schématique et partielle, d'un autre exemple d'accéléromètre 200 du type auquel s'appliquent, à titre d'exemple, des modes de réalisation décrits.

Dans l'exemple de la figure 2, l'accéléromètre 200 comporte une masse sismique 202 analogue à la masse sismique 102 de l'accéléromètre 100 (figure 1). En figure 2, la masse sismique 202 est reliée à des éléments fixes ou ancrages 204L et 204R par des éléments de transduction 206L et 206R, ou transducteurs. Les éléments de transduction 206L et 206R sont, par exemple, des éléments résonnants ou résonateurs, par exemple des poutres résonnantes. Dans l'orientation de la figure 2, les éléments résonnants 206L et 206R sont situés de part et d'autre de la masse 202 le long d'un axe horizontal Ox, de sorte que l'élément résonnant 206L, 206R relie la masse sismique 202 à l'ancrage 204L, 204R. Dit autrement, chaque élément résonnant 206L, 206R est lié d'une part à la masse sismique 202 et d'autre part à l'ancrage 204L, 204R.

Dans cet exemple, l'accéléromètre 200 est capable de détecter uniquement des accélérations qui possèdent une composante non nulle en projection sur l'axe Ox. En revanche, l'accéléromètre 200 n'est pas capable de détecter des accélérations qui possèdent une composante nulle suivant l'axe Ox, autrement dit des accélérations perpendiculaires à l'axe Ox (par exemple des accélérations vers le haut ou vers le bas, dans l'orientation de la figure 2). On qualifie alors l'accéléromètre 200 de capteur à un axe, ou capteur mono axe.

La masse sismique 202 et/ou les éléments résonnants 206L et 206R de l'accéléromètre 200 sont, par exemple, des microsystèmes électromécaniques (en anglais MicroElectroMechanical Systems - MEMS). En d'autres termes, la masse sismique 202 et/ou les éléments résonnants 206L et 206R possèdent par exemple au moins une dimension micrométrique, c'est-à-dire une dimension typiquement comprise entre dix micromètres (10 $\mu$m) et plusieurs centaines de micromètres, par exemple entre dix micromètres (10 $\mu$m) et cent micromètres (100 $\mu$m).

Les éléments résonnants 206L et 206R sont, par exemple, des poutres cylindriques (vues de côté en figure 2). À titre d'exemple, chaque poutre 206L, 206R présente un diamètre de l'ordre de plusieurs centaines de nanomètres, par exemple égal à environ deux cent cinquante nanomètres (250 nm). Les poutres 206L et 206R sont alors qualifiées de nanosystèmes électromécaniques (en anglais NanoElectroMechanical Systems - NEMS).

En variante, chaque poutre 206L, 206R est une poutre MEMS. Chaque poutre 206L, 206R présente alors, par exemple, un diamètre de l'ordre de plusieurs dizaines de micromètres, par exemple égal à environ cinquante micromètres (50 $\mu$m).

Au repos, la masse sismique 202 est située à égale distance des ancrages 204L et 204R en supposant, pour simplifier, que les éléments résonnants 206L et 206R sont identiques, aux dispersions de fabrication près. Les éléments résonnants 206L et 206R sont ainsi soumis à des contraintes équivalentes lorsque la masse sismique 202 est au repos. Les éléments résonnants 206L et 206R sont, par exemple, soumis chacun à une même tension mécanique, cette tension suffisant à maintenir la masse sismique 202 en suspension au-dessus d'un support (non représenté en figure 2).

Lorsque la masse sismique 202 subit une force F2 résultant, par exemple, d'une accélération a2 orientée vers l'ancrage 204L (c'est-à-dire vers la gauche, dans l'orientation de la figure 2), la masse sismique 202 tend alors à se rapprocher de l'ancrage 204L et à s'éloigner de l'ancrage 204R. La force F2 exerce ainsi des contraintes axiales, c'est-à-dire parallèles à l'axe Ox, sur les éléments résonnants 206L et 206R. Plus précisément, dans le cas où la force F2 est orientée vers l'ancrage 204L, l'élément résonnant 206L subit une contrainte en compression, tandis que l'élément résonnant 206R subit une contrainte en extension.

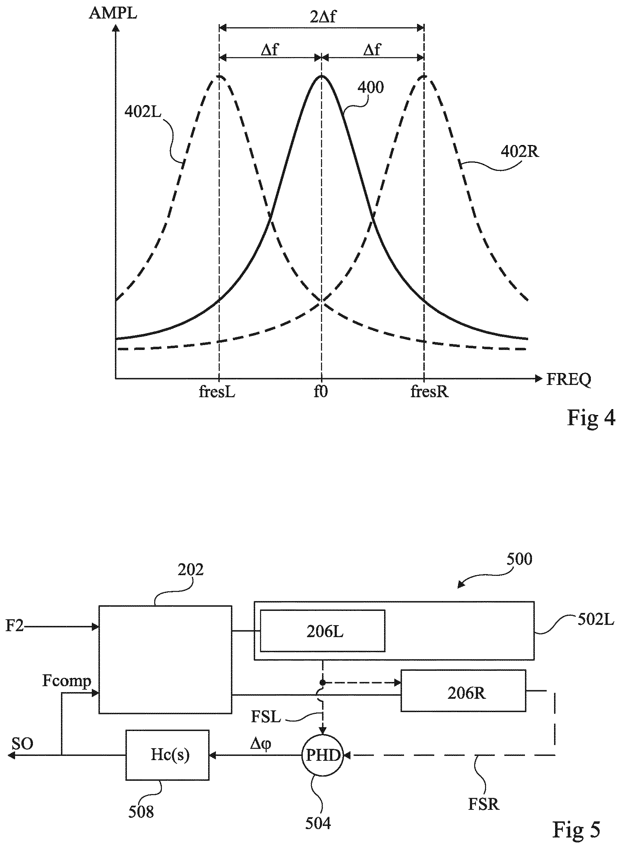

L'accéléromètre 200 de la figure 2 permet généralement d'atteindre une résolution supérieure à celle de l'accéléromètre 100 de la figure 1. Le fonctionnement de l'accéléromètre 200 est détaillé ci-après en relation avec les figures 3 et 4.

La figure 3 représente, de façon schématique et sous forme de blocs, un exemple de circuit 300 de commande d'un capteur. Le circuit de commande 300 fait par exemple partie de, ou est associé à, l'accéléromètre 200 de la figure 2.

En figure 3, on a symbolisé :

par des traits pleins, des liaisons véhiculant des signaux x(t) analogiques permettant de coder une information sous forme d'amplitude ; et
par des traits en pointillé, des liaisons véhiculant d'autres signaux x(t) analogiques permettant de coder une information sous forme de fréquence.

À titre d'exemple, les signaux x(t) symbolisés par des traits pleins en figure 3 sont de type :

[Math 1]

$$x(t) = B1 + a(t)$$

Dans l'équation Math 1 ci-dessus, B1 représente une constante et a(t) représente une amplitude variable en fonction du temps t.

À titre d'exemple, les signaux x(t) symbolisés par des traits en pointillé en figure 3 sont de type :

[Math 2]

$$x(t) = B2\,cos(2\pi \times f(t) \times t)$$

Dans l'équation Math 2 ci-dessus, B2 représente une constante et f(t) représente une fréquence variable en fonction du temps t.

L'information transmise se trouve dans la partie variable, c'est-à-dire la variation d'amplitude a(t) ou la variation de fréquence f(t).

Dans la suite de la description, on entend par circuit de commande d'un capteur un circuit électronique configuré pour commander ou piloter des éléments constitutifs de ce capteur, par exemple des éléments de transduction ou éléments résonnants, et/ou pour traiter des signaux issus de ces éléments de transduction ou éléments résonnants afin de produire, en sortie, un ou plusieurs signaux de mesure.

Le circuit de commande 300 comporte des blocs 302L et 302R symbolisant chacun une source de signal périodique de fréquence réglable. Lorsque l'accéléromètre 200 est en fonctionnement, la boucle d'asservissement 302L, 302R fournit un signal d'excitation périodique dont la fréquence est réglée de sorte à faire vibrer l'élément résonnant 206L, 206R au plus près de sa fréquence de résonance fresL, fresR.

Dans le cas où l'accéléromètre 200 est en position d'équilibre, les éléments résonnants 206L et 206R, supposés identiques, ont des fréquences de résonance respectives fresL et fresR de même valeur, notée f0. Dans la position d'équilibre, la boucle d'asservissement 302L, 302R excite donc l'élément résonnant 206L, 206R à une valeur de fréquence de résonance fresL, fresR égale à f0.

Dans le cas où la masse sismique 202 subit des accélérations, les contraintes exercées sur les éléments résonnants 206L et 206R sous l'action des déplacements latéraux de la masse sismique 202 entraînent des variations des fréquences de résonance respectives fresL et fresR des éléments résonnants 206L et 206R hors équilibre. Les boucles d'asservissement 302L et 302R du circuit 300 de l'accéléromètre 200 sont configurées pour s'adapter à ces variations des fréquences de résonance fresL et fresR, autrement dit pour régler les fréquences des signaux d'excitation des éléments résonnants 206L et 206R afin qu'elles correspondent aux fréquences fresL et fresR.

La boucle d'asservissement 302L, 302R est en particulier configurée de sorte que l'élément résonnant 206L, 206R soit excité à sa fréquence de résonance fresL, fresR quelle que soit l'accélération subie par la masse sismique 202, autrement dit quelle que soit la contrainte exercée sur l'élément résonnant 206L, 206R. On dit alors que l'accéléromètre 200 fonctionne en mode de détection résonnante.

En évaluant un écart ou décalage, noté Δf, de chaque fréquence de résonance fresL, fresR hors équilibre par rapport à la fréquence de résonance f0 à l'équilibre, on en déduit l'accélération a2 subie par la masse sismique 202. Le décalage Δf est, par exemple, évalué grâce à un mélangeur de fréquences 304 (FM). Dans l'exemple de la figure 3, une valeur 2Δf, correspondant au double du décalage Δf, c'est-à-dire à la différence entre les deux fréquences de résonance fresL et fresR hors équilibre, est transmise à un compteur de fréquence 306 (FC). En sortie du compteur de fréquence 306, on obtient par exemple un signal électrique proportionnel à l'accélération a2.

De manière plus générale, le compteur de fréquence 306 est par exemple adapté à convertir un signal analogique permettant de coder une information sous forme de fréquence en un autre signal analogique permettant de coder cette information, ou une image de cette information, sous forme d'amplitude.

En pratique, la fréquence de résonance fresL, fresR est recherchée en évaluant une amplitude du mouvement vibratoire de chaque élément résonnant 206L, 206R grâce à au moins un élément de transduction, par exemple piézorésistif. À titre d'exemple, on couple une jauge piézorésistive (non représentée) à chaque élément résonnant 206L, 206R de façon à obtenir un signal résistif proportionnel à son amplitude de vibration. En variante, les vibrations de chaque élément résonnant 206L, 206R sont par exemple converties en un signal analogique par un transducteur capacitif.

La détection résonnante mise en œuvre par le circuit 300 permet d'accéder à une gamme dynamique améliorée et est moins susceptible d'être impactée par des variations de température, notamment par rapport à d'autres méthodes de lecture par exemple capacitives ou piézorésistives dans lesquelles les éléments 206L et 206R n'entrent pas en résonance. Le circuit 300 est toutefois souvent complexe et coûteux, car il comporte une boucle d'asservissement 302L, 302R pour chaque élément résonnant 206L, 206R et un compteur de fréquence 306 comprenant généralement une source de signal de synchronisation de haute précision et des interfaces de traitement de signal numériques (non représentées en figure 3).

Les accéléromètres à détection résonnante sont parfois utilisables dans des plages d'accélérations restreintes dont les valeurs extrêmes sont liées à des contraintes mécaniques, par exemple à des limites de tenue au flambage ou à la rupture des éléments résonnants 206L et 206R. Pour s'affranchir de ces contraintes, on utilise le plus souvent un circuit de commande comportant une boucle de rétroaction en force (en anglais force feedback). Cela permet, en outre, d'éviter ou de limiter des résonances parasites de la masse sismique de l'accéléromètre considéré.

Dans le circuit 300, une telle boucle de rétroaction est par exemple obtenue grâce à un bloc 308 (Hc(s)) symbolisant un régulateur ou correcteur qui applique, en sortie du compteur de fréquence 306, une fonction de transfert Hc(s). Le régulateur 308 est, par exemple, un régulateur proportionnel, intégral et dérivé, ou régulateur PID. Le régulateur 308 est configuré pour exercer une force de compensation Fcomp, ou force de rétroaction, sur la masse sismique 202.

La force de compensation Fcomp possède, par exemple, une amplitude égale et un sens opposé à la force F2 (figure 2). En d'autres termes, le circuit 300 ajuste l'amplitude et le sens de la force de compensation Fcomp, au gré des variations d'accélération subies par la masse sismique 202 de l'accéléromètre 200, afin de compenser la force F2. La force de compensation Fcomp permet ainsi, malgré l'action de la force F2, de ramener la masse sismique 202 vers ou dans sa position d'équilibre, ce qui a pour effet de réduire ou de relâcher les contraintes mécaniques exercées sur les éléments résonnants 206L et 206R.

En pratique, la force de compensation Fcomp est, par exemple, une force électrostatique exercée sur la masse sismique 202 par une ou plusieurs électrodes (non représentées). Dans l'exemple de la figure 3, le circuit 300 produit un signal de sortie SO qui est par exemple égal ou proportionnel à une tension électrique utilisée pour appliquer la force électrostatique Fcomp.

La figure 4 est un graphique représentant des courbes caractéristiques de l'accéléromètre 200 de la figure 2. Le graphique de la figure 4 représente, plus précisément, des variations d'amplitude (axe des ordonnées, AMPL) des mouvements vibratoires des éléments résonnants 206L et 206R en fonction de la fréquence (axe des abscisses, FREQ) d'excitation des éléments résonnants 206L et 206R de l'accéléromètre 200 commandé par le circuit 300 de la figure 3.

En figure 4 :

une courbe 400 en trait plein représente des variations d'amplitude, en fonction de la fréquence, des mouvements vibratoires auxquels sont soumis les éléments résonnants 206L et 206R lorsque la masse sismique 202 est à l'équilibre ; et

des courbes 402L et 402R en trait pointillé représentent des variations d'amplitude, en fonction de la fréquence, des mouvements vibratoires auxquels sont respectivement soumis les éléments résonnants 206L et 206R lorsque la masse sismique 202 est hors équilibre.

Les courbes 402L et 402R proviennent, par exemple, d'une situation analogue à celle exposée en relation avec la figure 2, dans laquelle la masse sismique 202 est soumise à une accélération a2 dirigée vers l'ancrage 204L. Dans cette situation, par rapport à la position d'équilibre :

la fréquence de résonance fresL, qui diminue à cause de la compression de l'élément résonnant 206L, est alors égale à $f0 - \Delta f$ ; et

la fréquence de résonance fresR, qui augmente à cause de l'extension de l'élément résonnant 206R, est alors égale à $f0 + \Delta f$.

L'accélération a2 subie par la masse sismique 202 est alors proportionnelle à la différence entre les fréquences de résonance respectives fresL et fresR des éléments résonnants 206L et 206R, autrement dit proportionnelle à $2\Delta f$. On qualifie généralement l'accéléromètre 200 (figure 2) d'accéléromètre à détection résonnante différentielle, les deux éléments résonnants 206L et 206R étant positionnés de sorte que l'accélération a2 soit proportionnelle au décalage de leurs fréquences de résonance fresL et fresR.

Dans l'exemple représenté, le circuit 302L fournit, en sortie, un signal sinusoïdal de fréquence f0 + Δf tandis que le circuit 302R fournit, en sortie, un signal sinusoïdal de fréquence f0 - Δf.

En pratique, le mélangeur de fréquences 304 permet par exemple d'obtenir :

un signal basse fréquence, de fréquence sensiblement égale au décalage 2Δf entre les fréquences des signaux de sortie des circuits 302L et 302R ; et un autre signal haute fréquence, de fréquence sensiblement égale à 2f0.

À titre d'exemple, on ne conserve, en sortie du mélangeur de fréquences 304, que le signal image du décalage 2Δf. Le signal haute fréquence est par exemple filtré par le mélangeur de fréquences 304 ou par un autre composant (non représenté) situé en aval du mélangeur de fréquences 304, de façon à éliminer la composante de fréquence 2f0.

Un avantage des accéléromètres à détection résonnante différentielle tient au fait qu'ils ne sont pas sensibles (ou sont peu sensibles) à des variations de température car de telles variations affectent généralement simultanément et de la même façon les éléments résonnants 206L et 206R. En effet, bien qu'une variation de température puisse décaler les fréquences de résonance fresL et fresR, ce décalage, souvent sensiblement identique pour les deux éléments résonnants 206L et 206R, n'aura pas (ou aura peu) d'influence sur le résultat du calcul de la différence 2Δf entre les fréquences fresL et fresR.

On a décrit précédemment en relation avec les figures 1 et 2 des exemples d'accéléromètres 100, 200 dans lesquels la masse sismique 102, 202 n'est pas volontairement soumise à un mouvement vibratoire. Il existe néanmoins d'autres types d'accéléromètres, par exemple des accéléromètres résonnants qui comportent au moins une masse sismique que l'on fait vibrer à sa fréquence de résonance. Dans ce cas, une variation de la fréquence de résonance de la masse sismique permet de remonter à l'accélération subie. Il existe encore d'autres types d'accéléromètres, notamment des accéléromètres résonnants à détection résonnante. Un système semblable à l'accéléromètre 200 dont on ferait vibrer la masse sismique 202 à sa fréquence de résonance constitue un exemple d'un tel accéléromètre.

Bien que cela ne soit pas détaillé dans la présente description, les caractéristiques précédemment décrites en relation avec un exemple d'accéléromètre 200 à détection résonnante sont transposables par la personne du métier à des accéléromètres résonnants à détection résonnante. En particulier, l'adaptation du circuit de commande 300 à de tels accéléromètres est à la portée de la personne du métier à partir des indications ci-dessus.

La figure 5 représente, de façon schématique et sous forme de blocs, un mode de réalisation d'un circuit 500 de commande d'un capteur. Le circuit 500 fait par exemple partie de, ou est associé à, l'accéléromètre 200 de la figure 2.

En figure 5, de façon analogue à ce qui a été exposé précédemment en relation avec la figure 3, on a symbolisé :

par des traits pleins, des liaisons véhiculant des signaux x(t) analogiques permettant de coder une information sous forme d'amplitude ; et par des traits en pointillé, des liaisons véhiculant d'autres signaux x(t) analogiques permettant de coder une information sous forme de fréquence.

Selon un mode de réalisation, le circuit 500 comporte un bloc 502L symbolisant une boucle d'asservissement, par exemple une boucle à verrouillage de phase (en anglais Phase-Locked Loop - PLL) ou une boucle d'auto-oscillation. La boucle d'asservissement 502L du circuit 500 est, par exemple, analogue aux boucles d'asservissement 302L et 302R du circuit 300 exposées en relation avec la figure 3.

En particulier, lorsque l'accéléromètre 200 est en fonctionnement, la boucle d'asservissement 502L fournit un signal d'excitation périodique dont la fréquence est ajustée de sorte à faire vibrer l'élément résonnant 206L (figure 2) à une fréquence sensiblement égale, de préférence égale, à sa fréquence de résonance fresL. Dans le circuit 500, on utilise une sortie de la boucle d'asservissement 502L pour appliquer, à l'élément résonnant 206R, ce même signal d'excitation de fréquence fresL.

Dans le cas où l'accéléromètre 200 est en position d'équilibre, les éléments résonnants 206L et 206R, supposés identiques, sont tous deux en résonance et vibrent en phase à la même fréquence f0. Autrement dit, en position d'équilibre, les éléments résonnants 206L et 206R ont la même fréquence de résonance f0 et vibrent, l'un par rapport à l'autre, avec un déphasage nul.

Dans le cas où la masse sismique 202 subit des accélérations, les contraintes exercées sur les éléments résonnants 206L et 206R sous l'action des déplacements latéraux de la masse sismique 202 entraînent un déphasage des mouvements vibratoires des éléments résonnants 206L et 206R l'un par rapport à l'autre. Dans ce cas, bien que les éléments résonnants 206L et 206R soient tous deux excités à la même fréquence fresL, seul l'élément résonnant 206L est en résonance.

Cela provient du fait que, à la différence de la position d'équilibre, la fréquence de résonance fresL de l'élément résonnant 206L est dans ce cas, c'est-à-dire lorsque la masse sismique 202 est hors équilibre, différente de la fréquence de résonance fresR de l'élément résonnant 206R. Il en résulte que l'élément résonnant 206R vibre alors à la fréquence de résonance fresL de l'élément résonnant 206L, mais avec un déphasage non nul par rapport aux vibrations qui animent l'élément résonnant 206L.

Selon un mode de réalisation, le circuit 500 comporte un détecteur de phase 504 (PHD) ou comparateur de phase recevant, en entrée :

un signal FSL correspondant au signal périodique d'excitation de l'élément résonnant 206L à la fréquence fresL ; et
un autre signal FSR image de vibrations de l'élément résonnant 206R à la fréquence fresL, déphasées par rapport aux vibrations de l'élément résonnant 206L lorsque l'accéléromètre 200 subit une accélération.

Dans le mode de réalisation illustré en figure 5, le détecteur de phase 504 reçoit le signal FSL d'excitation de l'élément résonnant 206L et le signal FSR représentatif des vibrations, à la fréquence fresL, de l'élément résonnant 206R. En variante, le détecteur de phase 504 reçoit un signal image des vibrations de l'élément résonnant 206L et le signal FSR. Le détecteur de phase 504 est configuré pour évaluer un déphasage, noté $\Delta\varphi$, entre les signaux FSL et FSR.

Selon un mode de mise en œuvre, le déphasage $\Delta\varphi$ est évalué en valeur relative, le signe du déphasage $\Delta\varphi$ permettant alors d'indiquer le sens de l'accélération subie par la masse sismique 202 de l'accéléromètre 200 (figure 2). En variante, le déphasage $\Delta\varphi$ est évalué en valeur absolue, l'accélération étant dans ce cas supposée être toujours orientée dans le même sens.

Selon un mode de réalisation préféré, le déphasage $\Delta\varphi$ est transmis à un bloc 508 (Hc(s)) symbolisant un régulateur ou correcteur configuré pour appliquer, au déphasage $\Delta\varphi$, une fonction de transfert Hc(s).

Le bloc 508 d'application de la fonction de transfert Hc(s) est, par exemple, analogue au bloc 308 du circuit 300 de la figure 3. En particulier, le régulateur 508 du circuit 500 est, de préférence, un régulateur proportionnel et/ou intégral et/ou dérivé, plus préférentiellement un régulateur proportionnel, intégral et dérivé, ou régulateur PID. Le régulateur PID 508 permet de soumettre la masse sismique 202 à la force de compensation Fcomp comme exposé en relation avec la figure 3. Dans le mode de réalisation illustré en figure 5, le déphasage $\Delta\varphi$ est utilisé comme signal d'erreur de la boucle de rétroaction.

Les caractéristiques et avantages du bloc 308 du circuit 300 sont également applicables au bloc 508 du circuit 500. L'accéléromètre 200 équipé du circuit de commande 500 possède notamment une étendue de mesure, ou gamme de mesure, supérieure à celle d'un capteur analogue dont le circuit de commande serait dépourvu du bloc 508.

Un avantage du circuit 500 tient au fait qu'il ne comporte qu'une seule boucle d'asservissement 502L, contre deux boucles d'asservissement 302L et 302R dans l'exemple du circuit 300 de la figure 3. Le circuit 500 est par conséquent moins complexe, et susceptible d'être moins coûteux, que le circuit 300.

Un autre avantage du circuit 500 tient au fait qu'il ne comporte pas de compteur de fréquence 306, contrairement au circuit 300. Cela réduit encore davantage la complexité du circuit 500 par rapport au circuit 300.

En pratique, le détecteur de phase 504 du circuit 500 peut être réalisé à partir d'un circuit électronique simple, par exemple un circuit comportant six transistors. Contrairement au compteur de fréquence 306, un tel détecteur de phase 504 peut être dépourvu de source de signal d'horloge et/ou de composants numériques. Cela permet avantageusement de faire en sorte que le circuit 500 soit tout analogique, autrement dit qu'il ne comprenne aucun composant numérique.

Le circuit 500 permet, en tirant profit du déphasage $\Delta\varphi$ entre les vibrations des éléments résonnants 206L et 206R, de conserver les avantages de la détection résonnante décrits ci-dessus. Le circuit 500 possède en particulier des performances, par exemple une efficacité de transduction et une résolution, équivalentes à celles du circuit 300. Toutefois, le circuit 500 permet de s'affranchir des inconvénients liés aux mesures de fréquences de résonance telles que celles effectuées par le circuit 300.

On a décrit précédemment un mode de réalisation d'un circuit 500 de commande d'un accéléromètre 200, dans lequel les éléments résonnants 206L et 206R sont tous deux excités à la fréquence de résonance fresL de l'élément résonnant 206L par la boucle d'asservissement 502L. Cela n'est toutefois pas limitatif. La personne du métier est en particulier capable de prévoir un circuit de commande configuré pour exciter les éléments résonnants 206L et 206R de l'accéléromètre 200 à la fréquence de résonance fresR de l'élément résonnant 206R, grâce à une boucle d'asservissement associée à l'élément résonnant 206R, et pour évaluer le déphasage correspondant.

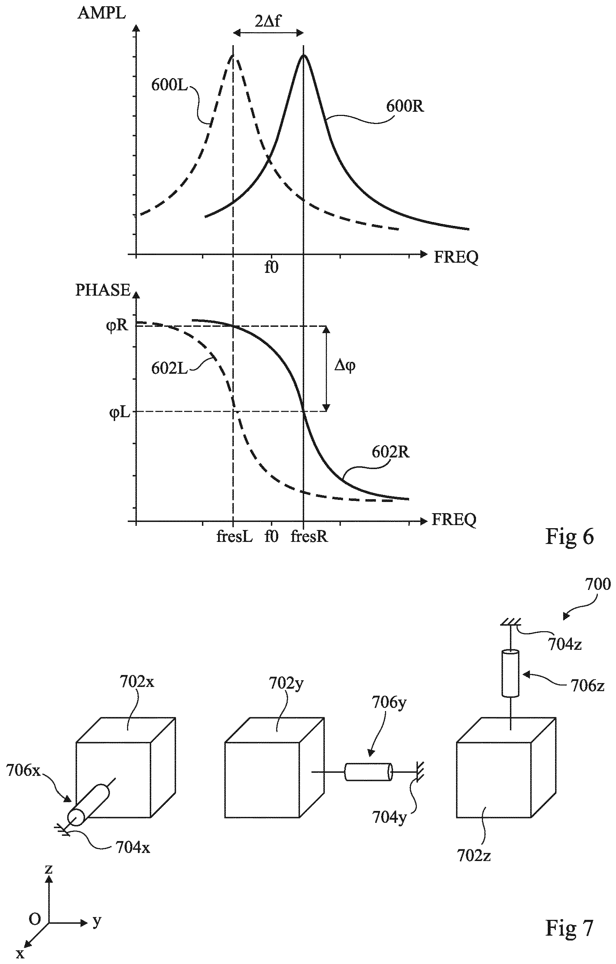

La figure 6 comprend des graphiques représentant d'autres courbes caractéristiques de l'accéléromètre 200 de la figure 2 commandé par le circuit 500 de la figure 5. Plus précisément, en figure 6 :

un graphique représente des variations d'amplitude (axe des ordonnées, AMPL) des mouvements vibratoires des éléments résonnants 206L et 206R en fonction de la fréquence (axes des abscisses, FREQ) d'excitation des éléments résonnants 206L et 206R ; et
un autre graphique représente des variations de phase (axe des ordonnées, PHASE) des mouvements vibratoires des éléments résonnants 206L et 206R en fonction de la fréquence (axes des abscisses, FREQ) d'excitation des éléments résonnants 206L et 206R.

En figure 6 :

des courbes 600L et 602L en trait pointillé représentent respectivement des variations d'amplitude et des variations de phase, en fonction de la fréquence, des mouvements vibratoires auxquels est soumis l'élément résonnant 206L lorsque la masse sismique 202 est hors équilibre ; et
des courbes 600R et 602R en trait plein représentent respectivement des variations d'amplitude et des variations de phase, en fonction de la fréquence, des mouvements vibratoires auxquels est soumis l'élément résonnant 206R lorsque la masse sismique 202 est hors équilibre.

Les courbes 600L et 600R de la figure 6 sont analogues aux courbes 402L et 402R de la figure 4. Ainsi, en figure 6, la différence entre les fréquences de résonance fresL et fresR des éléments résonnants 206L et 206R, c'est-à-dire entre les sommets des courbes 600L et 600R, est égale à 2$\Delta$f comme exposé précédemment en relation avec la figure 4.

Lorsque la masse sismique 202 (figure 2) est hors équilibre, et que les éléments résonnants 206L et 206R de l'accéléromètre 200 sont tous deux excités à la fréquence de résonance fresL de l'élément résonnant 206L, on note $\varphi$L et $\varphi$R les phases représentatives des vibrations auxquelles sont soumis les éléments résonnants 206L et 206R, respectivement. Comme illustré en figure 6, le déphasage $\Delta\varphi$ représente ici par convention l'écart $\varphi$L - $\varphi$R, évalué à l'aplomb du point d'inflexion de la courbe 602L à la fréquence fresL, entre les courbes 602L et 602R. Comme exposé précédemment, le déphasage $\Delta\varphi$ peut être considéré en valeur relative ou en valeur absolue, selon que l'on cherche, ou non, à déterminer le sens de l'accélération.

Dans l'exemple de la figure 6, à la fréquence fresL, la phase $\varphi$L est inférieure à la phase $\varphi$R. En valeur relative, selon la convention $\Delta\varphi$ = $\varphi$L - $\varphi$R, le déphasage $\Delta\varphi$ est alors négatif. Cela correspond à un déplacement de la masse sismique 202 de l'accéléromètre 200 vers l'ancrage 204L, c'est-à-dire vers la gauche dans l'orientation de la figure 2.

Bien que cela ne soit pas représenté en figure 6, lorsque la masse sismique 202 est en position d'équilibre :

les fréquences de résonance fresL et fresR sont égales à f0, le décalage $\Delta$f est donc nul et les courbes 600L et 600R sont alors superposées ; et
les phases $\varphi$L et $\varphi$R sont égales, le déphasage $\Delta\varphi$ est donc nul et les courbes 602L et 602R sont alors superposées.

On a décrit ci-dessus, en relation avec les figures 5 et 6, un mode de réalisation d'un circuit 500 de commande d'un exemple d'accéléromètre 200 (figure 2) dans lequel la masse sismique 202 applique des contraintes sur les éléments résonnants 206L et 206R par un couplage mécanique direct. Le circuit 500 peut toutefois commander d'autres exemples d'accéléromètres (non représentés), dans lesquels la masse sismique 202 applique des contraintes sur les éléments résonnants 206L et 206R :

par un couplage mécanique indirect, par exemple grâce à un ou plusieurs leviers ; ou
par un couplage électrique, le mouvement de la masse sismique 202 entraînant alors une variation d'un champ électrique interagissant avec chaque élément résonnant 206L, 206R.

On peut en outre prévoir que le circuit 500 commande encore d'autres exemples d'accéléromètres (non représentés), en particulier :

des accéléromètres comportant une masse sismique possédant deux modes de vibration couplés à l'accélération ; et
des accéléromètres comportant au moins deux masses sismiques en résonance, et dont les fréquences de résonance sont couplées à l'accélération.

De manière plus générale, on peut tirer profit du circuit 500 pour commander tout type de capteur dans lequel une grandeur physique entraîne une différence de phase entre un résonateur et au moins deux autres résonateurs, les résonateurs pouvant être liés à au moins une masse sismique ou bien être directement constitués par des masses sismiques en vibration.

On a par ailleurs décrit ci-dessus, en relation avec les figures 5 et 6, un mode de réalisation d'un circuit 500 de commande d'un exemple d'accéléromètre 200 (figure 2) dans lequel les deux éléments résonnants 206L et 206R possèdent la même fréquence de résonance en position d'équilibre. Lorsque l'accéléromètre 200 est soumis à une accélération a2, chaque élément résonnant 206L, 206R subit une variation de fréquence de résonance fresL, fresR identique, au signe près (fresL = f0 - $\Delta$f et fresR = f0 + $\Delta$f).

Selon le mode de réalisation de la figure 5, le circuit 500 applique alors une force de compensation Fcomp d'amplitude égale et de signe opposé à la force F2 résultant de l'accélération a2. Cela permet ainsi de ramener la masse sismique 202 en position d'équilibre ($\Delta$f = 0), où les fréquences de résonance fresL et fresR sont toutes deux égales à f0.

Selon un autre mode de réalisation, les deux éléments résonnants 206L et 206R de l'accéléromètre 200 de la figure 2 ont la même fréquence de résonance f0 en position d'équilibre, mais possèdent une sensibilité différente à l'accélération. Dans ce cas, on peut par exemple faire en sorte que, lorsque l'accéléromètre 200 est en fonctionnement et subit une accélération a2 :

la fréquence de résonance fresL de l'élément résonnant 206L soit égale à f0 - Δf ; et

la fréquence de résonance fresR de l'élément résonnant 206R soit égale à f0 + N.Δf, où N est, de préférence, un nombre entier naturel non nul.

En variante, on peut prévoir que seul l'un des deux éléments résonnants 206L, 206R, par exemple l'élément résonnant 206L, soit sensible à l'accélération. En d'autres termes, cela revient à faire en sorte que l'élément résonnant 206R ne soit pas sensible à l'accélération. On se ramène alors à un cas particulier du mode de réalisation précédent, pour lequel N = 0.

La figure 7 est une vue en perspective, schématique et partielle, d'encore autre exemple d'accéléromètre 700 du type auquel s'appliquent, à titre d'exemple, des modes de réalisation décrits.

Dans l'exemple de la figure 7, l'accéléromètre 700 comporte trois masses sismiques 702x, 702y et 702z analogues à la masse sismique 102 de l'accéléromètre 100 (figure 1). En figure 7, les masses sismiques 702x, 702y et 702z sont respectivement reliées à des éléments fixes ou ancrages 704x, 704y et 704z par des transducteurs ou éléments de transduction 706x, 706y et 706z. Les éléments de transduction 706x, 706y et 706z sont analogues aux éléments résonnants 206L et 206R de l'accéléromètre 200 (figure 2). En particulier, les éléments de transduction 706x, 706y et 706z, ou éléments résonnants, peuvent posséder des dimensions semblables à celles des éléments résonnants 206L et 206R. On suppose, pour simplifier, que les éléments résonnants 706x, 706y et 706z sont identiques entre eux, aux dispersions de fabrication près.

Dans l'orientation de la figure 7, les éléments résonnants 706x, 706y et 706z sont respectivement disposés le long de trois axes Ox, Oy et Oz orthogonaux formant un trièdre direct Oxyz. De cette manière, l'accéléromètre 700 est capable de détecter des accélérations dans les trois directions de l'espace. On qualifie alors l'accéléromètre 700 de capteur à trois axes, ou capteur tri axe.

On a représenté en figure 7 un exemple d'accéléromètre 700 dont chaque élément résonnant 706x, 706y, 706z est relié à une masse sismique 702x, 702y, 702z qui lui est propre. Toutefois, la personne du métier est capable d'adapter ce qui est décrit ci-dessus en relation avec l'accéléromètre 700 à d'autres types d'accéléromètres, notamment à des accéléromètres (non représentés) dans lesquels au moins deux éléments résonnants sont liés à une même masse sismique et, plus particulièrement, à des exemples d'accéléromètres où les éléments résonnants 706x, 706y et 706z sont tous trois liés à une même masse mécanique.

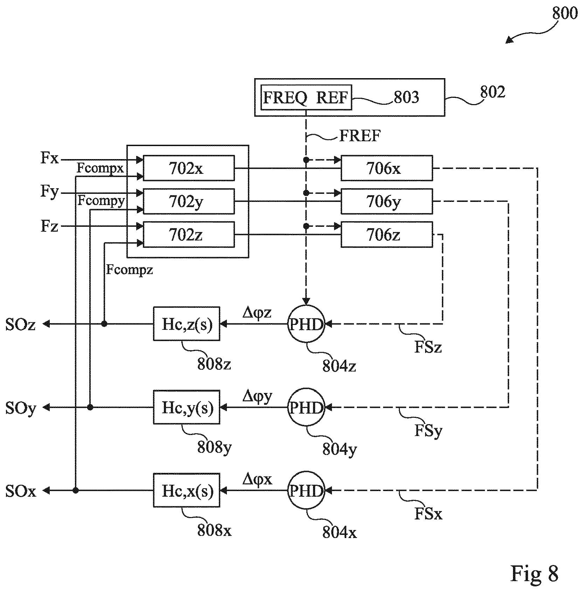

La figure 8 représente, de façon schématique et sous forme de blocs, un autre mode de réalisation d'un circuit 800 de commande d'un capteur. Le circuit 800 fait par exemple partie de, ou est associé à, l'accéléromètre 700 de la figure 7.

En figure 8, de façon analogue à ce qui a été exposé précédemment en relation avec la figure 3, on a symbolisé :

par des traits pleins, des liaisons véhiculant des signaux x(t) analogiques permettant de coder une information sous forme d'amplitude ; et

par des traits en pointillé, des liaisons véhiculant des signaux x(t) analogiques permettant de coder une information sous forme de fréquence.

Le circuit 800 comporte un bloc 802 symbolisant une boucle d'asservissement configurée pour régler la fréquence d'excitation d'un élément résonnant 803 (FREQ REF). Selon un mode de réalisation, l'élément résonnant 803 est un oscillateur et la boucle 802 est, par exemple, une boucle d'auto-oscillation ou une boucle à verrouillage de phase. La boucle d'asservissement 802 du circuit 800 est, par exemple, analogue aux boucles d'asservissement 302L et 302R du circuit 300 exposé en relation avec la figure 3.

Selon un mode de réalisation, l'élément résonnant 803 est découplé mécaniquement de l'accéléromètre 700, de sorte que l'élément résonnant 803 n'est pas sensible aux accélérations auxquelles est soumis l'accéléromètre 700. L'élément résonnant 803 est, par exemple, analogue aux éléments résonnants 706x, 706y et 706z (figure 7), l'élément résonnant 803 n'étant toutefois lié mécaniquement à aucune des masses sismiques 702x, 702y et 702z de l'accéléromètre 700.

Lorsque l'accéléromètre 700 est en fonctionnement, l'élément résonnant 803 est soumis à un signal FREF d'excitation périodique de fréquence sensiblement égale, de préférence égale, à sa fréquence de résonance. Dans le cas où les éléments résonnants 803, 706x, 706y et 706z sont identiques entre eux, la fréquence du signal FREF est en outre sensiblement égale, de préférence égale, à la fréquence de résonance des éléments résonnants 706x, 706y et 706z en position d'équilibre, c'est-à-dire lorsque l'accéléromètre 700 n'est soumis à aucune accélération.

Dans la présente description, on suppose pour simplifier que les éléments résonnants 706x, 706y et 706z possèdent tous, en position d'équilibre, une fréquence de résonance égale à celle de l'élément résonnant 803. Toutefois, en pratique, cela n'est pas forcément le cas. La fréquence de résonance de l'élément résonnant 803 peut notamment être différente de celle des éléments résonnants 706x, 706y et 706z à l'équilibre. Les fréquences de résonance des éléments résonnants 706x, 706y et 706z à l'équilibre peuvent, en outre, être différentes les unes des autres. Ces différences sont, par exemple, évaluées et prises en compte par le circuit 800 lors d'étapes de calibration pouvant avoir lieu après fabrication de l'accéléromètre 700 et/ou pendant l'utilisation de l'accéléromètre 700.

Dans le cas où l'accéléromètre 700 est en position d'équilibre, les éléments résonnants 803, 706x, 706y et 706z sont supposés être en résonance et vibrer tous en phase à la même fréquence. Dit autrement, en position d'équilibre, les éléments résonnants 803, 706x, 706y et 706z vibrent, les uns par rapport aux autres, avec un déphasage nul.

Dans le cas où la masse sismique 702x, 702y, 702z subit une accélération le long de l'axe Ox, Oy, Oz, la contrainte Fx, Fy, Fz exercée sur l'élément résonnant 706x, 706y, 706z sous l'action du déplacement latéral de la masse sismique 702x, 702y, 702z entraîne un déphasage des mouvements vibratoires de l'élément résonnant 706x, 706y, 706z par rapport au signal périodique FREF, supposé inchangé. Cela provient du fait que la fréquence de résonance hors équilibre de l'élément résonnant 706x, 706y, 706z est différente de la fréquence de résonance de ce même élément résonnant 706x, 706y, 706z lorsque la masse sismique 702x, 702y, 702z est en position d'équilibre.

Selon un mode de réalisation, le circuit 800 comporte des détecteurs de phase 804x, 804y et 804z (PHD). Le détecteur de phase 804x, 804y, 804z reçoit, en entrée :

le signal périodique FREF d'excitation de l'élément résonnant 803 ; et
un autre signal FSx, FSy, FSz image des vibrations de l'élément résonnant 706x, 706y, 706z, ces vibrations étant déphasées par rapport au signal FREF lorsque la masse sismique 702x, 702y, 702z est hors équilibre.

Dans le mode de réalisation illustré en figure 8, chaque détecteur de phase 804x, 804y, 804z est propre à l'un des éléments résonnants 706x, 706y et 706z. Le détecteur de phase 804x, 804y, 804z est configuré pour évaluer un déphasage, noté $\Delta\varphi x$, $\Delta\varphi y$, $\Delta\varphi z$, entre le signal FSx, FSy, FSz image des vibrations de l'élément résonnant 706x, 706y, 706z et le signal FREF de référence. Selon un mode de réalisation préféré, le déphasage $\Delta\varphi x$, $\Delta\varphi y$, $\Delta\varphi z$ est ensuite transmis à un bloc 808x (Hc,x(s)), 808y (Hc,y(s)), 808z (Hc,z(s)) symbolisant l'application d'une fonction de transfert Hc,x(s), Hc,y(s), Hc, z (s) .

Selon un mode de réalisation, on fait en sorte que, lorsque le capteur 700 est en fonctionnement, la fréquence de résonance de l'élément résonnant 803 et la fréquence de résonance de l'élément résonnant 706x, 706y, 706z soient proches, et dans la bande passante l'une de l'autre. Plus précisément, en supposant que l'élément résonnant 803 possède une fréquence de résonance f1 et un facteur de qualité Q1 et que l'élément résonnant 706x, 706y, 706z possède, hors équilibre, une fréquence de résonance f2 et un facteur de qualité Q2, on fait de préférence en sorte que |f1 - f2| < (f1/ Q1) et que |f1 - f2| < (f2/Q2).

Le bloc 808x, 808y, 808z d'application de la fonction de transfert Hc,x(s), Hc,y(s), Hc,z(s) est, par exemple, similaire au bloc 308 du circuit 300 de la figure 3. De façon analogue à ce qui a été exposé en relation avec la figure 3, la fonction de transfert Hc,x(s), Hc,y(s), Hc,z(s) appliquée par le bloc 808x, 808y, 808z du circuit 800 est, de préférence, une fonction de régulation PID (proportionnelle, intégrale, dérivée) permettant de soumettre la masse sismique 702x, 702y, 702z à une force de compensation Fcompx, Fcompy, Fcompz. Dans le mode de réalisation illustré en figure 8, le déphasage $\Delta\varphi x$, $\Delta\varphi y$, $\Delta\varphi z$ est utilisé comme signal d'erreur de la boucle de rétroaction.

Les caractéristiques et avantages du bloc 308 du circuit 300 sont également applicables aux blocs 808x, 808y et 808z du circuit 800. L'accéléromètre 700 équipé du circuit de commande 800 possède notamment une étendue de mesure, ou gamme de mesure, supérieure à celle d'un accéléromètre dont le circuit de commande serait dépourvu des blocs 808x, 808y et 808z.

En pratique, la force de compensation Fcompx, Fcompy, Fcompz est, par exemple, une force électrostatique exercée sur la masse sismique 702x, 702y, 702z par une ou plusieurs électrodes (non représentées). Dans l'exemple de la figure 8, le circuit 800 produit des signaux de sortie SOx, SOy et SOz qui sont par exemple égaux ou proportionnels à des tensions électriques utilisées pour appliquer les forces électrostatiques Fcompx, Fcompy et Fcompz, respectivement.

Dans le circuit 800, l'élément résonnant 803 de référence n'est pas sensible aux accélérations tandis que les trois autres éléments résonnants 706x, 706y et 706z sont sensibles, respectivement, à des accélérations suivant les axes Ox, Oy et Oz. Chaque élément résonnant 706x, 706y, 706z possède sa propre boucle de rétroaction permettant de produire la force de compensation Fcompx, Fcompy, Fcompz le long de l'axe Ox, Oy, Oz considéré. Le déphasage $\Delta\varphi x$, $\Delta\varphi y$, $\Delta\varphi z$ de chaque élément résonnant 706x, 706y, 706z est alors comparé avec l'élément résonnant 803 de référence. Cela permet avantageusement de compenser des dérives en température susceptibles d'affecter l'accéléromètre 700.

De manière générale, plus un accéléromètre possède un nombre élevé d'éléments résonnants, et plus l'utilisation d'un circuit du type du circuit 800 exposé en relation avec la figure 8 est avantageuse. Cela provient notamment du fait que le circuit 800 utilise un élément résonnant 803 de référence qui est commun à tous les autres éléments résonnants 706x, 706y, 706z de l'accéléromètre 700.

On a décrit ci-dessus en relation avec la figure 8 un mode de réalisation d'un circuit 800 dont l'élément résonnant 803 et les éléments résonnants 706x, 706y et 706z possèdent les mêmes modes de résonance.

Selon un autre mode de réalisation, l'élément résonnant 803 est différent des éléments résonnants 706x, 706y et 706z, mais l'élément résonnant 803 et les éléments résonnants 706x, 706y et 706z possèdent au moins un mode de résonance à la même fréquence.

Selon encore un autre mode de réalisation, l'élément résonnant 803 est différent des éléments résonnants 706x, 706y et 706z, mais l'élément résonnant 803 et les éléments résonnants 706x, 706y et 706z possèdent des fréquences de résonance proportionnelles. Dans ce cas, la fréquence f2 de résonance de chaque élément résonnant 706x, 706y, 706z est par exemple un multiple de la fréquence f1 de résonance de l'élément résonnant 803 (f2 = N.f1, où N est un entier naturel supérieur à 1). Le circuit 800 comporte alors de préférence un multiplicateur de fréquences (non représenté) en sortie de l'élément résonnant 803.

Dans le circuit 800, l'un des éléments résonnants 803, 706x, 706y et 706z (l'élément résonnant 803, selon le mode de réalisation illustré en figure 8) est mis en résonance grâce à une boucle d'asservissement ou de rétroaction (la boucle 802, toujours selon ce mode de réalisation). Cela permet avantageusement de faire en sorte que le signal FREF soit toujours maintenu à la fréquence f1 de résonance de l'élément résonnant 803 même en cas de dérive de fréquence due, par exemple, à une variation de température.

En variante, l'élément résonnant 803 n'est pas piloté par la boucle de rétroaction 802. L'élément résonnant 803 est alors par exemple commandé par un auto-oscillateur ou par un générateur de fréquences. Dans ce cas, on suppose par exemple que l'accéléromètre 700 n'est pas sensible aux variations de température.

Selon encore un autre mode de réalisation, au moins un élément résonnant, parmi l'élément résonnant 803 de référence et les éléments résonnants 706x, 706y et 706z, possède un mécanisme (non représenté) de régulation de sa fréquence de résonance. Dans ce cas, cela permet avantageusement de compenser un biais susceptible d'affecter l'accéléromètre 700 en position d'équilibre.

Par exemple, au moins un capteur de température mesure la température de l'accéléromètre 700 (figure 7) et/ou du circuit 800 (figure 8). Dans ce cas, la fréquence f1 de résonance de l'élément résonnant 803 est par exemple ajustée en fonction de la température mesurée par le capteur.

Selon encore un autre mode de réalisation, la compensation du biais susceptible d'affecter l'accéléromètre 700 en position d'équilibre est effectuée grâce à l'application d'une force de compensation statique s'ajoutant à, ou se cumulant avec, au moins l'une des forces de compensation Fcompx, Fcompy et Fcompz.

On a décrit ci-dessus en relation avec la figure 8 un mode de réalisation d'un circuit 800 dont la force de compensation Fcompx, Fcompy, Fcompz est issue d'une fonction de transfert Hc,x(s), Hc,y(s), Hc,z(s) de type PID. La fonction de transfert Hc,x(s), Hc,y(s), Hc,z(s) est de préférence appliquée par un bloc 808x, 808y, 808z analogique.

Selon un autre mode de réalisation, le signal représentatif du déphasage Δφx, Δφy, Δφz est préalablement numérisé. Dans ce cas, l'application de la fonction de transfert Hc,x(s), Hc,y(s), Hc,z(s) s'effectue de préférence par un bloc 808x, 808y, 808z numérique.

En variante, chacun des signaux FSx, FSy, FSz est numérisé avant le détecteur de phase 804x, 804y, 804z associé. La personne du métier est en mesure d'adapter le circuit 800 à cette variante.

De façon générale, les signaux de sortie SOx, SOy et SOz du circuit 800 sont générés à partir des signaux de sortie des blocs 808x, 808y et 808z d'application des fonctions de transfert Hc,x(s), Hc,y(s) et Hc,z(s), respectivement.

Selon un mode de réalisation, les signaux de sortie SOx, SOy et SOz du circuit 800 sont identiques aux signaux de sortie des blocs 808x, 808y et 808z.

Selon un autre mode de réalisation, les signaux de sortie SOx, SOy et SOz du circuit 800 sont proportionnels aux signaux de sortie des blocs 808x, 808y et 808z.

Plus généralement, selon encore un autre mode de réalisation, les signaux de sortie SOx, SOy et SOz du circuit 800 sont fonction des signaux de sortie des blocs 808x, 808y et 808z. Le signal de sortie SOx, SOy, SOz dépend par exemple du signal de sortie du bloc 808x, 808y, 808z selon une fonction polynomiale, par exemple une fonction polynomiale d'ordre deux.

On a décrit ci-dessus en relation avec la figure 7 un exemple d'accéléromètre 700 dont les éléments résonnants 706x, 706y et 706z sont directement liés aux masses sismiques 702x, 702y et 702z, respectivement.

Dans un autre exemple (non représenté), l'accéléromètre comporte au moins une masse sismique mécaniquement liée à deux poutres identiques par un bras de levier possédant un gain noté Γ. Dans ce cas, une accélération, notée a, communiquée à la masse sismique provoque, sur les poutres, des contraintes opposées et d'amplitude Tacc proportionnelle à aΓ. Les poutres sont alors utilisées comme des résonateurs dont la fréquence de résonance, notée fR, varie selon une équation du type :

[Math 3]

$$fR = f0 + \sqrt{k.Tacc}$$

Dans l'équation Math 3 ci-dessus, f0 représente la fréquence de résonance en position d'équilibre, c'est-à-dire la fréquence de résonance de chaque poutre en l'absence de contrainte (Tacc = 0), et k représente un facteur dépendant de la géométrie des poutres. Sous l'effet de l'accélération a, les deux résonateurs subissent une contrainte qui a pour effet de modifier leurs fréquences de résonance respectives. On se ramène ainsi à un cas analogue à ce qui a été décrit précédemment en relation avec l'accéléromètre 200 de la figure 2.

Divers modes de réalisation et variantes ont été décrits. La personne du métier comprendra que certaines caractéristiques de ces divers modes de réalisation et variantes pourraient être combinées, et d'autres variantes apparaîtront à la personne du métier. En particulier, la personne du métier est capable d'adapter les circuits 500 et 800 à des modes de réalisation d'accéléromètres comportant un nombre quelconque de masses sismiques et d'éléments résonnants. Les modes de réalisation décrits en relation avec l'accéléromètre 700 et le circuit 800 sont par ailleurs transposables par la personne du métier à l'accéléromètre 200 et au circuit 500.

En outre, ce qui a été décrit plus précisément en relation avec des exemples d'application à des accéléromètres s'applique plus généralement à d'autres capteurs à détection résonnante, notamment des gyromètres à détection résonnante pour lesquels on cherche à obtenir un couplage d'au moins deux résonateurs, ou modes de résonance, ayant un décalage en fréquence de résonance le plus précis possible en vue d'atteindre de meilleures performances. Dans ce cas, les boucles de rétroaction sont préférentiellement utilisées pour modifier la fréquence de résonance de l'un des modes, de façon à pouvoir optimiser la différence des fréquences.

Enfin, la mise en œuvre pratique des modes de réalisation et variantes décrits est à la portée de la personne du métier à partir des indications fonctionnelles données ci-dessus. En particulier, le choix des valeurs des fréquences d'excitation des éléments résonnants est à la portée de la personne du métier.

**Revendications**

1. Procédé de commande d'un capteur (200 ; 700) microélectromécanique comportant une seule boucle à verrouillage de phase ou une seule boucle d'auto-oscillation (502L), le procédé comprenant les étapes suivantes :

a) exciter, par un premier signal périodique (FSL ; FREF) provenant de la boucle à verrouillage de phase ou de la boucle d'auto-oscillation, un premier élément résonnant (206L ; 803), le premier signal présentant une fréquence sensiblement égale, de préférence égale, à la fréquence de résonance (fresL ; f1) du premier élément résonnant ;

b) exciter, par le premier signal, à la fréquence de résonance du premier élément résonnant (206L ; 803), un ou plusieurs deuxièmes éléments résonnants (206R ; 706x, 706y, 706z) couplés respectivement à une ou plusieurs masses sismiques (202 ; 702x, 702y, 702z) ; et

c) évaluer, par un ou plusieurs détecteurs de phase (504 ; 804x, 804y, 804z), un ou plusieurs déphasages (Δφ ; Δφx, Δφy, Δφz) entre le premier signal et un ou plusieurs deuxièmes signaux (FSR ; FSx, FSy, FSz) images respectivement de vibrations, à la fréquence de résonnance du premier élément résonnant (206L ; 803), du ou des deuxièmes éléments résonnants (206R ; 706x, 706y, 706z), dans lequel chaque déphasage (Δφ ; Δφx, Δφy, Δφz) est fonction d'une accélération (a2) subie par la masse sismique couplée audit deuxième élément résonnant et est utilisé comme signal d'erreur dans une boucle de rétroaction en force (508) appliquant, à ladite masse sismique, une force de compensation (Fcomp ; Fcompx, Fcompy, Fcompz) permettant de ramener la masse sismique vers sa position d'équilibre.

2. Procédé selon la revendication 1, dans lequel, à l'équilibre, les premier (206L ; 803) et deuxième (206R ; 706x, 706y, 706z) éléments résonnants vibrent avec un déphasage nul l'un par rapport à l'autre.

3. Procédé selon la revendication 1 ou 2, dans lequel chaque deuxième élément résonnant (206R ; 706x, 706y, 706z) possède, lorsque le capteur (200 ; 700) est en position d'équilibre, une fréquence de résonance (fresR ; f2) sensiblement égale, de préférence égale, à la fréquence de résonance (fresL, f1) du premier élément résonnant (206L ; 803).

4. Procédé selon l'une quelconque des revendications 1 à 3, dans lequel le premier signal (FSL ; FREF) est imposé au premier élément résonnant (206L ; 803) par une boucle d'asservissement (502L ; 802).

5. Procédé selon l'une quelconque des revendications 1 à 4, dans lequel le déphasage (Δφ ; Δφx, Δφy, Δφz) est évalué par un détecteur de phase (504 ; 804x, 804y, 804z) propre à chaque deuxième élément résonnant (206R ; 706x, 706y, 706z).

6. Procédé selon l'une quelconque des revendications 1 à 5, dans lequel la force de rétroaction (Fcomp ; Fcompx, Fcompy, Fcompz) est produite par une boucle de rétroaction comportant un régulateur (508 ; 808x, 808y, 808z), de préférence un régulateur proportionnel et/ou intégral et/ou dérivé, plus préférentiellement un régulateur proportionnel, intégral et dérivé.

7. Procédé selon l'une quelconque des revendications 1 à 6, dans lequel le premier élément résonnant (206L ; 803) est découplé mécaniquement de ladite ou desdites masses sismiques (202 ; 702x, 702y, 702z).

8. Capteur (200) à un axe comportant :

- une masse sismique (202) reliée à des éléments fixes (204R, 204R) par le premier élément résonnant (206L) et par exactement un deuxième élément résonnant (206R), les premier et deuxième éléments résonnants étant situés de part et d'autre de la masse sismique ; et
- un circuit (300) adapté à mettre en œuvre le procédé selon l'une quelconque des revendications 1 à 7, le circuit comprenant :

> la boucle à verrouillage de phase ou la boucle d'auto-oscillation (502L) ;
> exactement un détecteur de phase (504) recevant les premier (FSL) et deuxième (FSR) signaux périodiques ; et
> la boucle de rétroaction en force (508).

9. Capteur (700) à trois axes comportant :

> - trois masses sismiques (702x, 702y, 702z) respectivement reliées à des éléments fixes (704x, 704y, 704z) par exactement trois deuxièmes éléments résonnants (706x, 706y, 706z) disposés le long de trois axes orthogonaux ; et
> - un circuit adapté à mettre en œuvre le procédé selon l'une quelconque des revendications 1 à 7, le circuit comprenant :

>> la boucle à verrouillage de phase ou la boucle d'auto-oscillation (802) ;
>> exactement trois détecteurs de phase (804x, 804y, 804z) recevant les premier (FREF) et deuxièmes (FSx, FSy, FSz) signaux périodiques ; et
>> trois boucles de rétroaction en force (808x, 808y, 808z).

10. Accéléromètre comportant au moins un capteur (200 ; 700) selon la revendication 8 ou 9.

11. Gyromètre comportant au moins un capteur (200 ; 700) selon la revendication 8 ou 9.


**Patentansprüche**

1. Verfahren zum Steuern eines mikroelektromechanischen Sensors (200; 700), aufweisend eine einzelne Phasenregelschleife oder eine einzelne selbstoszillierende Schleife (502L), wobei das Verfahren die folgenden Schritte umfasst:

> Erregen, mit einem gleichen ersten periodischen Signal (FSL; FREF) der Phasenregelschleife oder der selbstoszillierenden Schleife, eines ersten Resonanzelements (206L; 803), wobei das erste Signal eine Frequenz aufweist, die im Wesentlichen gleich, vorzugsweise gleich, der Resonanzfrequenz (fresL; f1) des ersten Resonanzelements ist;
> Anregen, mit dem ersten Signal, bei der Resonanzfrequenz des ersten Resonanzelements (206L; 803), eines oder einer Vielzahl von zweiten Resonanzelementen (206R; 706x, 706y, 706z), die jeweils mit einer oder einer Vielzahl von seismischen Massen (202; 702x, 702y, 702z) gekoppelt sind; und
> Schätzen, durch einen oder eine Vielzahl von Phasendetektoren (504; 804x, 804y, 804z), einer oder einer Vielzahl von Phasenverschiebungen ($\Delta\varphi$; $\Delta\varphi$x, $\Delta\varphi$y, $\Delta\varphi$z) zwischen dem ersten Signal und einem oder einer Vielzahl von zweiten Signalen (FSR; FSx, FSy, FSz), die jeweils Bilder von Schwingungen, bei der Resonanzfrequenz des ersten Resonanzelements (206L; 803), des oder der zweiten Resonanzelemente (206R; 706x, 706y, 706z) sind,

> wobei jede Phasenverschiebung ($\Delta\varphi$; $\Delta\varphi$x, $\Delta\varphi$y, $\Delta\varphi$z) eine Funktion einer Beschleunigung (a2) ist, die von der seismischen Masse, die mit dem zweiten Resonanzelement gekoppelt ist, erfahren wird, und als ein Fehlersignal in einer Kraft-Rückkopplungsschleife (508) verwendet wird, die auf die seismische Masse eine Kompensationskraft (Fcomp; Fcompx, Fcompy, Fcompz) ausübt, die es ermöglicht, die seismische Masse in ihre Gleichgewichtslage zu bringen.

2. Verfahren nach Anspruch 1, wobei im Gleichgewicht das erste (206L; 803) und das zweite (206R; 706x, 706y, 706z) Resonanzelement mit einer Phasenverschiebung von Null zueinander schwingen.

3. Verfahren nach Anspruch 1 oder 2, wobei jedes zweite Resonanzelement (206R; 706x, 706y, 706z), wenn sich der Sensor (200; 700) in einer Gleichgewichtslage befindet, eine Resonanzfrequenz (fresR; f2) hat, die im Wesentlichen gleich, vorzugsweise gleich, der Resonanzfrequenz (fresL, f1) des ersten Resonanzelements (206L; 803) ist.

4. Verfahren nach einem der Ansprüche 1 bis 3, wobei das erste Signal (FSL; FREF) dem ersten Resonanzelement (206L; 803) durch eine Rückkopplungsschleife (502L; 802) aufgeprägt wird.

5. Verfahren nach einem der Ansprüche 1 bis 4, wobei die Phasenverschiebung ($\Delta\varphi$; $\Delta\varphi$x, $\Delta\varphi$y, $\Delta\varphi$z) durch einen Phasendetektor (504; 804x, 804y, 804z) geschätzt wird, der für jedes zweite Resonanzelement (206R; 706x, 706y, 706z) spezifisch ist.

6. Verfahren nach einem der Ansprüche 1 bis 5, wobei die Rückkopplungskraft (Fcomp; Fcompx, Fcompy, Fcompz) durch eine Rückkopplungsschleife generiert wird, die einen Regler (508; 808x, 808y, 808z) aufweist, vorzugsweise einen Proportional- und/oder Integral- und/oder Differentialregler, besonders bevorzugt einen Proportional-Integral-Differentialregler.

7. Verfahren nach einem der Ansprüche 1 bis 6, wobei das erste Resonanzelement (206L; 803) mechanisch von der/den seismischen Masse(n) (202; 702x, 702y, 702z) entkoppelt ist.

8. Einachsiger Sensor (200), der Folgendes aufweist:

- eine seismische Masse (202), die mit festen Elementen (204R, 204R) durch das erste Resonanzelement (206L) und durch genau ein zweites Resonanzelement (206R) gekoppelt ist, wobei sich das erste und das zweite Resonanzelement auf beiden Seiten der seismischen Masse befinden; und
- eine Schaltung (300), die geeignet ist, das Verfahren nach einem der Ansprüche 1 bis 7 durchzuführen, wobei die Schaltung Folgendes aufweist:

die Phasenregelschleife oder die selbstoszillierende Schleife (502L);
genau einen Phasendetektor (504), der die ersten (FSL) und zweiten (FSR) periodischen Signale empfängt; und
die Kraft-Rückkopplungsschleife (508).

9. Dreiachsiger Sensor (700), der Folgendes aufweist:

- drei seismische Massen (702x, 702y, 702z), die jeweils mit festen Elementen (704x, 704y, 704z) durch genau drei zweite Resonanzelemente (706x, 706y, 706z) gekoppelt sind, die entlang dreier orthogonaler Achsen angeordnet sind; und
- eine Schaltung, eingerichtet zur Durchführung des Verfahrens nach einem der Ansprüche 1 bis 7, wobei die Schaltung Folgendes aufweist:

die Phasenregelschleife oder die selbstoszillierende Schleife (802);
genau drei Phasendetektoren (804x, 804y, 804z), die die ersten (FSL) und zweiten (FSx, FSy, FSz) periodischen Signale empfangen; und
drei Kraft-Rückkopplungsschleifen (808x, 808y, 808z).

10. Beschleunigungsmesser, der wenigstens einen Sensor (200; 700) nach Anspruch 8 oder 9 aufweist.

11. Gyrometer, das wenigstens einen Sensor (200; 700) nach Anspruch 8 oder 9 aufweist.

**Claims**

1. Method of controlling a microelectromechanical sensor (200; 700) comprising a single phase-locked loop or a single self-oscillating loop (502L), the method comprising the following steps:

exciting, with a same first periodic signal (FSL; FREF) from the phase-locked loop or from the self-oscillating loop, a first resonant element (206L; 803), the first signal having a frequency substantially equal, preferably equal, to the resonance frequency (fresL; f1) of the first resonant element;
exciting, with the first signal, at the resonance frequency of the first resonant element (206L; 803), one or a plurality of second resonant elements (206R; 706x, 706y, 706z) respectively coupled to one or a plurality of seismic masses (202; 702x, 702y, 702z); and
estimating, by one or a plurality of phase detectors (504; 804x, 804y, 804z), one or a plurality of phase shifts ($\Delta\varphi$; $\Delta\varphi x$, $\Delta\varphi y$, $\Delta\varphi z$) between the first signal and one or a plurality of second signals (FSR; FSx, FSy, FSz) which are respectively images of vibrations, at the resonance frequency of the first resonant element (206L; 803), of the second resonant element(s) (206R; 706x, 706y, 706z),

wherein each phase shift ($\Delta\varphi$; $\Delta\varphi x$, $\Delta\varphi y$, $\Delta\varphi z$) is a function of an acceleration (a2) undergone by the seismic mass coupled to said second resonant element and is used as an error signal in a force feedback loop (508) applying, to said seismic mass, a compensation force (Fcomp; Fcompx, Fcompy, Fcompz) enabling to bring the seismic mass towards its equilibrium position.

2. Method according to claim 1, wherein, at equilibrium, the first (206L; 803) and second (206R; 706x, 706y, 706z) resonant elements vibrate with a zero phase shift with respect to each other.

3. Method according to claim 1 or 2, wherein each second resonant element (206R; 706x, 706y, 706z) has, when the sensor (200; 700) is in a position of equilibrium, a resonance frequency (fresR; f2) substantially equal, preferably equal, to the resonance frequency (fresL, f1) of the first resonant element (206L; 803).

4. Method according to any one of claims 1 to 3, wherein the first signal (FSL; FREF) is imposed to the first resonant element (206L; 803) by a feedback loop (502L; 802).

5. Method according to any one of claims 1 to 4, wherein the phase shift ($\Delta\varphi$; $\Delta\varphi x$, $\Delta\varphi y$, $\Delta\varphi z$) is estimated by a phase detector (504; 804x, 804y, 804z) specific to each second resonant element (206R; 706x, 706y, 706z).

6. Method according to any one of claims 1 to 5, wherein the feedback force (Fcomp; Fcompx, Fcompy, Fcompz) is generated by a feedback loop comprising a regulator (508; 808x, 808y, 808z), preferably a proportional and/or integral and/or derivative regulator, more preferably a proportional integral derivative regulator.

7. Method according to any one of claims 1 to 6, wherein the first resonant element (206L; 803) is mechanically uncoupled from said seismic mass(es) (202; 702x, 702y, 702z).

8. One-axis sensor (200) comprising:

- one seismic mass (202) coupled to fixed elements (204R, 204R) by the first resonant element (206L) and by exactly one second resonant element (206R), the first and second resonant elements being located on either side of the seismic mass; and
- a circuit (300) adapted to implementing the method according to any one of claims 1 to 7, the circuit comprising:

  the phase-locked loop or the self-oscillating loop (502L);
  exactly one phase detector (504) receiving the first (FSL) and second (FSR) periodic signals; and
  the force feedback loop (508).

9. Three-axis sensor (700) comprising:

- three seismic masses (702x, 702y, 702z) respectively coupled to fixed elements (704x, 704y, 704z) by exactly three second resonant elements (706x, 706y, 706z) arranged along three orthogonal axes; and
- a circuit adapted to implementing the method according to any one of claims 1 to 7, the circuit comprising:

  the phase-locked loop or the self-oscillating loop (802);
  exactly three phase detectors (804x, 804y, 804z) receiving the first (FSL) and seconds (FSx, FSy, FSz) periodic signals; and
  three force feedback loops (808x, 808y, 808z).

10. Accelerometer comprising at least one sensor (200; 700) according to claim 8 or 9.

11. Gyrometer comprising at least one sensor (200; 700) according to claim 8 or 9.

Fig 1

Fig 2

Fig 3

Fig 4

Fig 5

Fig 6

Fig 7

Fig 8

EP 3 889 617 B1

## RÉFÉRENCES CITÉES DANS LA DESCRIPTION

**Documents brevets cités dans la description**

- EP 3301398 A

- US 2009064781 A

**Littérature non-brevet citée dans la description**

- **NAN-CHYUAN TSAI et al.** Fabrication and analysis of a micro-machined tri-axis gyroscope. *J. Micromech. Microeng.*, 2008, vol. 18, 115014